# EUROPEAN PATENT SPECIFICATION

(11) **EP 0 439 064 B1**
(45) Date of publication and mention of the grant of the patent: **03.04.1996**
(21) Application number: 91100544.5
(22) Date of filing: 18.01.1991
(51) Int. Cl.: C30B 25/02, C30B 29/40

(54) **Method of epitaxially growing compound crystal and doping method therein**
Verfahren zum epitaktischen Wachstum und Dotierung eines Verbindungskristalls
Procédé de croissance épitaxiale d'un cristal d'un composé et procédé pour son dopage

(30) Priority: 19.01.1990 JP 8399/90
(43) Date of publication of application: 31.07.1991
(73) Proprietor: Research Development Corporation of Japan, Chiyoda-ku Tokyo (JP); Kurabayashi, Toru, Sendai-shi Miyagi-ken (JP); Nishizawa, Jun-ichi, Sendai-shi, Miyagi-ken 980 (JP)
(72) Inventor: Kurabayashi, Toru, Taihaku-ku, Sendai-shi, (JP); Nishizawa Jun-ichi, Aoba-ku, Sendai-shi (JP)
(74) Representative: Sparing Röhl Henseler Patentanwälte

(56) References cited:
- GB-A- 2 162 206
- GB-A- 2 192 198
- JOURNAL OF CRYSTAL GROWTH, vol. 98, nos. 1/2, 1st November 1989, pages 195-208, Elsevier Science Publishers B.V. (North-Holland Physics Publishing Division), Amsterdam, NL; S.P. DenBAARS et al.: "Atomic layer epitaxy of compound semiconductors with metalorganic precursors"
- EXTENDED ABSTRACTS OF THE 19TH CONFERENCE ON SOLID STATE DEVICES AND MATERIALS, Tokyo, 25th - 27th August 1987, pages 475-478; M. OZEKI et al.: "Growth of AlGaAs by atomic layer epitaxy using a pulsed vapor phase method"

## Description

The present invention relates to a method of epitaxially growing a compound semiconductor crystal on a substrate crystal, wherein a plurality of crystal component gases of a compound semiconductor and reaction gas chemically reacting with the crystal component gases are alternately directed individually onto the substrate crystal heated under vacuum, and to a method of doping a compound semiconductor crystal during epitaxially growing said compound semiconductor crystal on a substrate crystal, wherein a plurality of crystal component gases of a compound semiconductor and reaction gas chemically reacting with the crystal component gases are alternately directed individually onto the substrate crystal heated under vacuum, and wherein a dopant compound gas is introduced for doping a grown layer.

Conventionally, molecular beam epitaxy (hereinafter referred to as "MBE"), metal organic-chemical vapor deposition (hereinafter referred to as "MO-CVD") and the like are generally employed as a technique for growth of a thin-film crystal for a semiconductor, for example. Particularly, in the case of a compound semiconductor, these methods have widely been used in manufacturing of a semiconductor device.

The aforesaid MO-CVD has widely been utilized for the reason that an apparatus for the MO-CVD can be used in which its structure or construction is relatively simple and easy and which is low in cost, for the reason that productivity is superior in which
growing speed or rate is high and in which growing time is short, and for other reasons. However, it has been impossible for the MO-CVD to control growing film thickness of the order of a monomolecular layer.

The doping technique due to the MO-CVD has been arranged such that compound gas of an element for forming a semiconductor and compound gas of dopant are simultaneously directed onto a substrate crystal.

Further, the aforementioned MBE uses a method in which a raw material is heated and vaporized, and the vapor is evaporated or deposited onto the substrate crystal while controlling a molecular beam. A crystal film is extremely thin, and it is possible to sufficiently control composition, profile and crystal growing rate. Accordingly, the MBE is superior in controllability of the growing film thickness as compared with the aforesaid MO-CVD.

The doping method in the MBE is arranged such that vapor of a dopant element is vaporized onto the substrate crystal, simultaneously together with vapor of a constitutional element which serves as a raw material.

In order to produce a crystal superior in quality by the MBE, it is required for the case of, for example, GaAs to set the crystal growing temperature to high temperature of 500°C to 600°C . It will become a problem that, because the temperature is high, in the case where steep or sharp impurity profile such as npn and pnp is produced, the impurities are redistributed. Further, since the MBE is based on an evaporation method, there are a problem of deviation from stoichiometry composition of a growing film, and a problem of high density of surface defects such as oval defect or the like.

Because of these defects, in recent years, attention has been paid to molecular-layer epitaxy (hereinafter referred to as "MLE") having controllability of film thickness of the order of a monomolecular layer.

The MLE is a method in which, in the case of crystal growth of III-group through V-group compounds, III-group compound gas and V-group compound gas are alternately directed onto a substrate crystal, and the crystal is grown a monomolecular layer by a monomolecular layer.

This technique is reported in a paper [J. Nishizawa, H. Abe and T. Kurabayashi; J. Electrochem. Soc. 132 (1985) 1197 - 1200] written by Jun-ichi Nishizawa et al, for example.

The aforesaid MLE utilizes adsorption and surface reaction of the compound gasses and, in the case of, for example, III- through V-group crystals, produces a monomolecular-film growing layer by introduction of the III-group compound gas and the V-group compound gas one by one.

In the manner described above, since the MLE utilizes monomolecular-layer adsorption of the compound gasses, growth can be done always of the order of the monomolecular layer within a certain pressure range even if pressures of the introducing gasses varies.

Furthermore, the MLE utilizes trimethylgallium (TMG) that is alkylgallium and arsine (AsH₃) that is a hydrogen compound of arsenic. However, in place of the above-mentioned TMG, the MLE uses triethylgallium (TEG) that is alkylgallium, whereby it is possible to produce a GaAs growing layer high in purity, by growth at further low temperature.

This technique is reported in a paper [J. Nishizawa, H. Abe, T. Kurabayashi and N. Sakurai: J. Vac. Sci. Technol. A4(3), (1986) 706 - 719] written by Jun-ichi Nishizawa et al, for example.

Moreover, the doping method of the GaAs due to the MLE is carried into practice such that, in addition to the compound gasses of the TEG and AsH₃, the compound gas of dopant is successively directed onto a surface of the substrate crystal separately. By doing so, it is possible to produce a crystal high in purity, which is controlled in impurity, including a high-dope crystal, at low temperature.

Furthermore, since the MLE grows the crystal film under low temperature, redistribution of impurities is extremely low, so that it is possible to realize steep or sharp impurity profile.

This technique is reported in a paper [J. Nishizawa, H. Abe and T. Kurabayashi; J. Electrochem. Soc. Vol. 136, No. 2, pp. 478 - 484 (1989)] written by Jun-ichi Nishizawa et al, for example.

By the way, in order to produce, for example, a high-speed semiconductor device, it will be required to produce a growing film of impurity density further high in concentration, and to realize crystal growing at further low temperature.

From GB-A-2 192 198 it is known to produce a compound semiconductor by growing a plurality of molecular layers one over another. For this, while a carrier gas and a small quantity of hydride containing an element of group V or VI are continuously flown over a substrate, an organometallic compound diluted with a carrier gas and containing a group III or II element, a hydride which is diluted with a carrier gas at a concentration higher than that continuously flowing over the substrate and which contains a group V or VI element and hydrogen halide are alternately introduced as a repeating cycle with interruptions between the separate introductions over the substrate so that an atomic layer of a group III or II element and an atomic layer of a group V or VI element are alternatively grown over the substrate. In any step a doping element containing compound may be introduced.

It is an object of the invention to provide a method of epitaxially growing a compound crystal, which is capable of producing a crystal high in purity, at low-temperature growth, on the basis of a principal concept of molecular-layer epitaxy.

It is another object of the invention to provide a doping method in epitaxial growth of a compound crystal, which is capable of producing a growing film of impurity density high in concentration, strictly impurity-controlled at low temperature, of the order of a monomolecular layer.

To achieve these objects the method of epitaxially growing a compound semiconductor crystal is characterized in that as reaction gas one is used which is one of crystal component gases which is different in type from the crystal component gases directed onto the substrate crystal in precedence.

Further, the method of doping a compound semiconductor crystal during epitaxially growing, especially according to the inventive method of epitaxially growing, is characterized in that said dopant compound gas is introduced separately from the crystal component gas followed by the introduction of said reaction gas.

Within this doping method it is preferred to use as reaction gas the crystal component gas which is different in type from the dopant compound gas directed onto the substrate crystal is precedence, or to use as reaction gas a dopant compound gas which is different in type from the crystal component gases directed onto the substrate crystal is precedence is used, or to use as reaction gas a dopant compound gas which is different in type from the dopant compound gas directed onto the substrate crystal is precendence is used.

As dopant compound gas a compound gas containing Si, Ge, S, Se, Te, Zn, Cd or Mg may be used.

The reaction gas chemically reacting with the crystal compound gases and the dopant compound gas may be directed onto the substrate crystal in overlapping relationship to the dopant compound gas.

The reaction gas may be only partially overlapped with the dopant compound gas.

Within these methods crystal component gases containing group III and group V elements are useful.

With the above arrangement of the invention, it is possible to produce a crystal high in purity, by growth at low temperature.

Further, in the above doping method it is possible to produce a crystal which is strictly impurity-controlled at low temperature.

If the crystal component gasses are alternately directed onto the substrate heated under vacuum, surface adsorption or crytallization accompanied with accumulation and surface reaction occurs successively, so that the semiconductor monomolecular crystal is grown a monomolecular layer by a monomolecular layer.

For example, for crystal growth of GaAs, the crystal component gasses utilize TMG (trimethylgallium), TEG (triethylgallium), DMGaCl (dimethylgallium chloride), DEGaCl (diethylgallium chloride), or GaCl₃ (gallium trichloride), as a raw-material gas of Ga.

Moreover, AsH₃ (arisine), TMAs (trimethylarsenic), TEAs (triethylarsenic), or AsCl₃ (arsenic trichloride) is employed as a raw-material gas of As.

In the case of growth of AlGaAs, TMA (trimethylaluminium), TEA (triethylaluminium), TIBA (triisobutylaluminium), DMAlH (dimethylaluminium hydride), DEAlH (diethylaluminium hydride), DMAlCl (dimethylaluminium chloride), DEAlCl (diethylaluminium chloride), or AlCl₃ (aluminum trichloride) is used as a raw material of Al in addition to the raw-material gasses of Ga and As.

After or during the raw-material gasses of Ga, As and Al have been or are introduced, the reaction gas chemically reacting with the aforesaid gasses is fed, whereby it is possible to remove an alkyl group such as a methyl group, an ethyl group or the like and a functional group of the surface adsorbent such as Cl, H or the like.

By doing so, it is possible to prevent pollution or contamination of C (carbon) from the alkyl group and mixing of Cl into or with the crystal.

Further, by removal of the aforementioned H, atoms of a substance that is the raw material are exposed to the surface, whereby the raw-material gas supplied at the next time is surface-adsorbed efficiently. Thus, strict control of the monomolecular-layer growth can be made possible.

In the doping method in the crystal growing method of the above-described GaAs and AlGaAs, the compound gas containing the dopant is also introduced for a predetermined period of time. That is, the component gasses and the compound gas of dopant are separately introduced in the predetermined order.

The compound gas of dopant includes, as a compound of n-type impurity, a VI-group organic metal such as DMSe (dimethyl selenium), DESe (diethyl selenium), DMS (dimethyl sulfur), DES (diethyl sulfur), DMTe (dimethyl tellurium), DETe (diethyl tellurium) or the like, a VI-group hydrogen compound such as H₂S (hydrogen sulfide), H₂Se (hydrogen selenide) or the like, or a IV-group compound such as SiH₄, Si₂H₆, Si₃H₈, Si(CH₃)₄ or the like.

Furthermore, as the compound of p-type impurity, there is DMZn (dimethylzinc), DE2n (diethylzinc), DMCd (dimethylcadmium), DECd (diethylcadmium), Bi-CPMg (bis-cyclopentadienyl magnesium), C (carbon) and the like from the methyl group such as GeH₄ and TMG, or the like.

In order to direct these gasses onto the substrate crystal to efficiently take in the crystal as donor and acceptor, it is required to remove the regaining functional group bonded with the element on the crystal surface after introduction of these gasses. For this reason, the reaction gas is introduced in various phases after or during the compound gas of dopant has been or is introduced, and the functional group is removed by the surface reaction, whereby doping of the pure element is made possible.

Further, since doping is done at a process of growth a molecular layer by a molecular layer, site of the crystal can be controlled which the dopant enters. Thus, it is possible to produce a crystal which is doped and which is high in safety.

As described above, the method of epitaxially growing the compound crystal, according to the invention, is arranged such that the reaction gas is directed onto the substrate crystal in the predetermined order in addition to the crystal component gasses. Thus, it is possible to produce the crystal high in purity, at low temperature.

Furthermore, the doping method in the epitaxial crystal growth for the compound crystal is arranged such that the reaction gas is directed onto the substrate crystal heated under vacuum in the predetermined order, in addition to the crystal component gasses and the dopant compound gas. Thus, it is possible to produce the crystal strictly impurity-controlled at low temperature. Further, it is possible to produce the crystal to which impurities are added at high concentration.

### DETAILED DESCRIPTION OF THE DRAWINGS

Fig. 1 is a schematic view of an epitaxial growing apparatus for carrying out an epitaxial growing method for a chemical compound crystal, according to an embodiment of the invention, the epitaxial growing apparatus comprising an AlₓGaₓ₋₁As and/or GaAs molecular-layer epitaxial growing device, using reaction gas;
Fig. 2 is graphical representation showing a gas introducing method in molecular-layer epitaxy of non-dope GaAs in the case where H₂ is used as reaction gas;
Figs. 3(A) through 3(C) are graphical representation showing a gas introducing method in molecular-layer epitaxy of non-dope AlₓGa₁₋ₓAs in the case where H₂ is used as the reaction gas;
Fig. 4(A) is graphical representation showing a doping method due to a C mode in the molecular-layer epitaxy of GaAs; and
Fig. 4(B) is a graphical representation showing a doping method due to an A mode in the molecular-layer epitaxy of GaAs; and
Fig. 5 is a time chart relating to the conventional gas introducing method of dopant compound gas in molecular-layer epitaxy.

### DESCRIPTION OF THE EMBODIMENTS

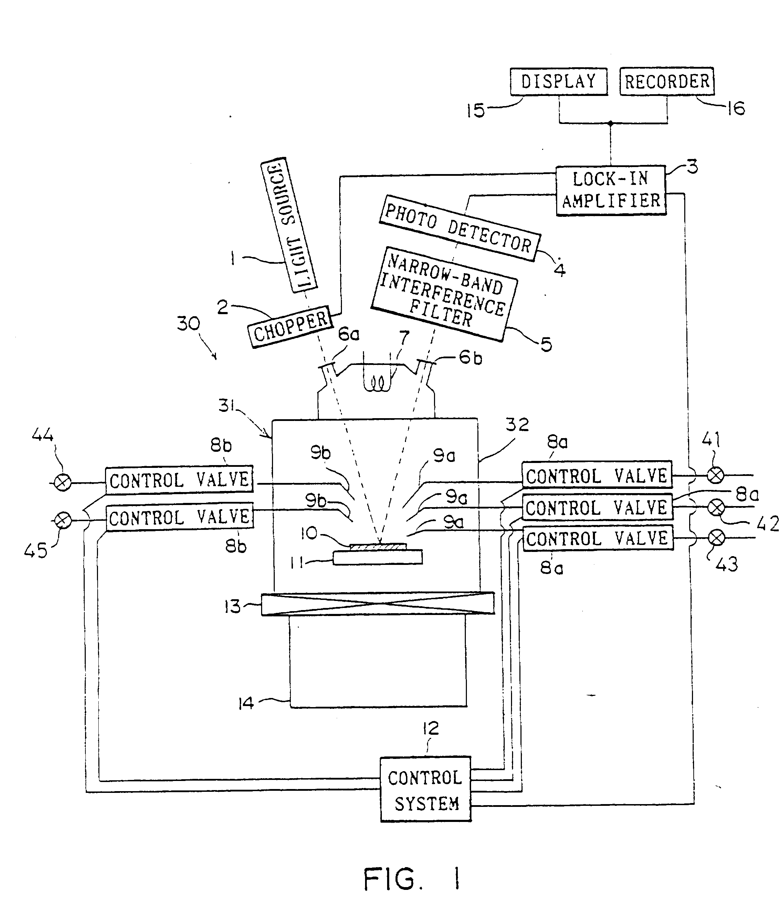

Referring first to Fig. 1, there is shown an epitaxial growing apparatus which comprises a GaAs and/or AlₓGa₁₋ₓAs molecular-layer epitaxial growing device 30. The epitaxial growing device 30 is reported in a paper [J. Nishizawa, H. Abe and T. Kurabayashi: J. Electrochem. Soc. 132 (1985) 1197 - 1200] written by Jun-ichi Nishizawa et al, for example.

As shown in Fig. 1, the GaAs and/or AlₓGa₁₋ₓAS molecular-layer epitaxial growing device 30 comprises a hermetic or closed container 31 in which a closed crystal growing chamber 32 is defined. For example, pressure within the crystal growing chamber 32 is evacuated. for the first time, to 0,133 x 10⁻³ to 0,133 x 10⁻⁸ Pa (10⁻⁶ to 10⁻¹¹ Torr) and, subsequently, chemical compound gasses that are a raw material are introduced into the crystal growing chamber 32 at 13,33 to 0,133 x 10⁻⁴ Pa (10⁻¹ to 10⁻⁷ Torr)with predetermined sequence while the crystal growing chamber 32 is evacuated. A gate valve 13 is arranged at a location below the closed container 31. A vacuum evacuation device 14 such as a turbo molecular pump or the like is arranged at a location below the gate valve 13. The crystal growing chamber 32 is arranged at a location above the gate valve 13. A GaAs single-crystal substrate susceptor 11 and a GaAs single-crystal substrate 10 are accommodated within che crystal growing chamber 32. Further, within the crystal growing chamber 32, a plurality of component-gas introducing nozzles 9a connected respectively to ports 41 through 43, and a pair of reaction-gas introducing nozzles 9b connected respectively to ports 44 and 45. are arranged in opposed relation to each other, in facing relation to the GaAs single-crystal substrate 10. The component gasses are comprised by Al compound, Ga compound and As compound. The introducing nozzles 9a and the reaction-gas introducing nozzles 9b are provided with their respective control valves 8a and 8b. These control valves 8a and 8b are connected to a control system 12.

Reaction gas is introduced into the crystal growing chamber 32 through the control valves 8b and the nozzles 9b, respectively. On the other hand, the Al compound gas and the Ga compound gas are introduced into the crystal growing chamber 32 through two of the valves 8a and corresponding two of the nozzles 9a, respectively, AsH₃ that is one of the crystal component gasses is introduced into the crystal growing chamber 32 through the remaining valve 8a and the remaining nozzle 9a.

Furthermore, a GaAs single-crystal substrate heating element 7 is arranged at an upper portion of the crystal growing chamber 32. An incident window 6a and an extracting window 6b, through which a light can pass, are provided at a periphery of the crystal growing chamber 32 and are arranged respectively on both sides of the GaAs single-crystal substrate heating element 7.

The arrangement is such that the light from a light source 1 is emitted to a growing film of the GaAs single-crystal substrate 10 from a predetermined direction. The light source 1 is arranged on the outside of the incident window 6a in facing relation thereto. The light source 1 is a source of a parallel beam, and is selected from a He-Ne laser, a semiconductor laser, a light-emitting diode, a mercury lamp and an argon ion laser. A chopper 2 for chopping the light is arranged between the incident window 6a and the light source 1. Moreover, a photo detector 4 for the light reflected from the GaAs single crystal substrate 10 is arranged on the outside of the extracting window 6b in facing relation thereto. A narrow-band interference filter 5 for removing a stray light from the reflected light is arranged between the extracting window 6b and the photo detector 4.

The chopper 2 and the photo detector 4 are connected to a lock-in amplifier 3. The lock-in amplifier 3 is provided with a display 15 and a recorder 16. The lock-in amplifier 3 is connected to the control system 12.

In operation, the control valves 8a and 8b for the reaction gas, the compound gas and the crystal component gasses are first controlled by the control system 12. By doing so, the Al compound gas and the Ga compound gas are alternately introduced into the crystal growing chamber 32 and are directed onto the GaAs single-crystal substrate 10 which is controlled in temperature by the GaAs single-crystal substrate heating element 7, so that GaAs and/or AlₓGa₁₋ₓ is epitaxially grown.

The reflected-light intensity at the GaAs crystal surface is measured as follows. That is, first, the light from the light source 1 arranged on the outside of the closed container 31 is chopped by the chopper 2. The light chopped is emitted to the GaAs single crystal through the incident window 6a. The light reflected is detected by the photo detector 4 such as an Si photodiode or the like, through the other extracting window 6b. The filter 5 is arranged between the photo detector 4 and the extracting window 6b, and removes the stray light from the light incident upon the photo detector 4 before the detection. A detecting output from the photo detector 4 is processed in signal by the lock-in amplifier 3. Subsequently, outputs are successively issued from the lock-in amplifier 3 to the control system 12, the display 15 and the recorder 16.

Regarding the above-described epitaxial growing apparatus, reference should be made to U.S. Serial No. 617,554. filed on November 26, 1990, entitled "METHOD OF AND APPARATUS FOR EPITAXIALLY GROWING CHEMICAL-COMPOUND CRYSTAL".

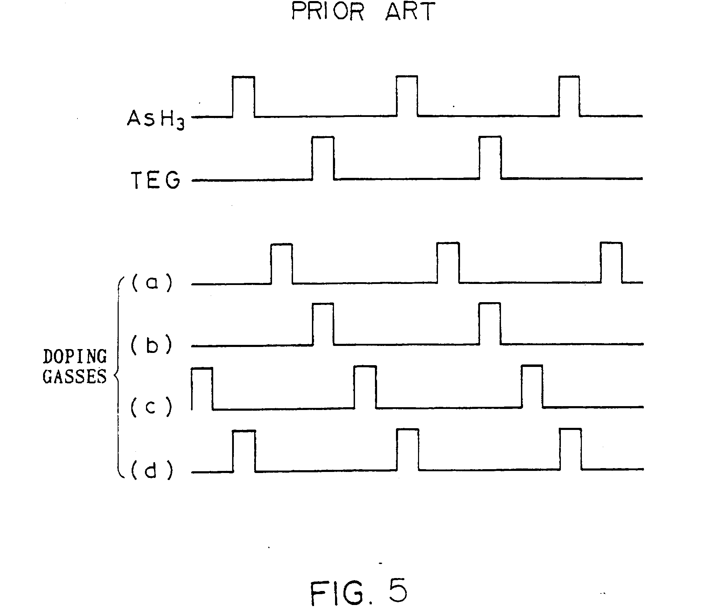

Prior to describe the preferred embodiment of the invention, the conventional doping method will first be described with reference to Fig. 5. Fig. 5 shows a time chart relating to a doping method which has conventionally been carried into practice, in molecular-layer epitaxy. That is, Fig. 5 illustrates an example of molecular-layer epitaxy for GaAs of [TEG - AsH₃].

Specifically, in a crystal growing method in which TEG and AsH₃ are alternately introduced, with their respective predetermined pressures for predetermined time, into the crystal growing chamber 32 illustrated in Fig. 1 and are directed onto the substrate crystal 10, any one of the following gas-introducing modes (a) through (d) is selected, and chemical compound gasses are directed onto the substrate crystal 10:
(a) Mode in which the compound gas of dopant is introduced in synchronism with evacuation of AsH₃;
(b) Mode in which the compound gas of dopant is introduced in synchronism with introduction of TEG;
(c) Mode in which the compound gas of dopant is introduced in synchronism with evacuation of TEG; and
(d) Mode in which the compound gas of dopant is introduced in synchronism with introduction of AsH₃.

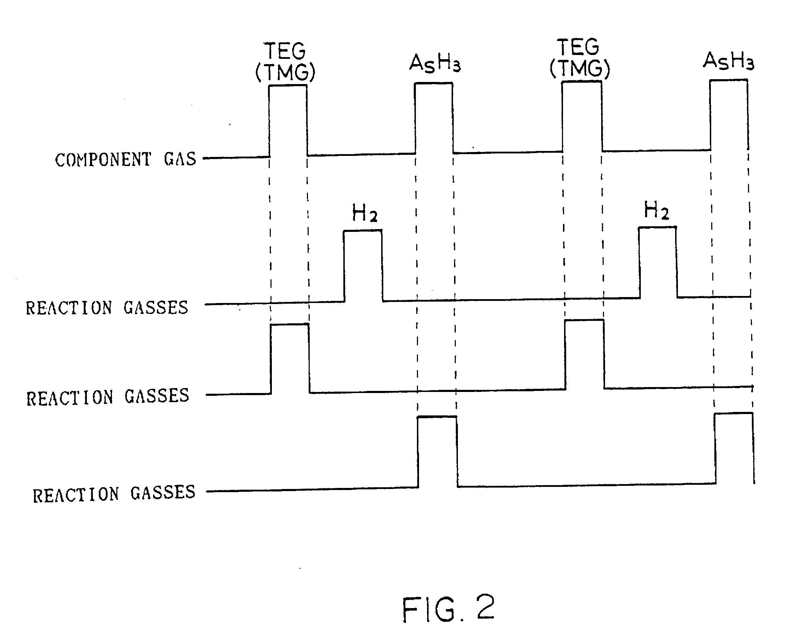

Referring next to Fig. 2, there is shown an embodiment of epitaxial crystal growth of a GaAs molecular layer of non-dope, according to the invention.

The crystal component gasses include TEG or TMG as raw-material gas of Ga, and AsH₃ as raw-material gas of As. Further, H₂ is used as reaction gas which reacts with the crystal component gasses.

These gasses are introduced into the crystal growing chamber and are directed onto the substrate crystal heated under vacuum, with gas introducing procedure illustrated in Fig. 2. As the method of introduction of the gasses chemically reacting, the arrangement may be such that the gasses are introduced simultaneously with TEG or in a manner of partially or completely overlapped with the TEG.

In the manner described above, organic metal gas of Ga is directed onto the substrate crystal and, subsequently, H₂ that is the reaction gas is introduced. By doing so, C₂H₅ or CH₃ within Ga - (C₂H₅)ₓ (0 < x ≦ 3) or Ga - (CH₃)ₓ (0 < x ≦ 3), which forms a surface adsorption layer, reacts with H₂ and is desorbed. Accordingly, it is possible to form an epitaxial crystal growing film, with which C (carbon) is not mixed, on the substrate crystal. It is also possible to realize crystal growth at low temperature.

As the component gas of Ga, there are DMGaCl. DEGaCl and GaCl₃, other than the gasses referred to above. If however, the reaction gas H₂ is introduced after introduction of the above-described gasses, it is possible to produce a GaAs crystal high in purity, in a manner similar to that described previously.

Further, in the case where organic metal gas and chloride such as TMAₛ, TEAₛ, AₛCl₃ and the like are used as the component gas of As, the reaction gas H₂ is introduced after the above-mentioned gas has been introduced, whereby it is possible to produce a GaAs crystal high in purity, by low-temperature growth, in a manner similar to that described above.

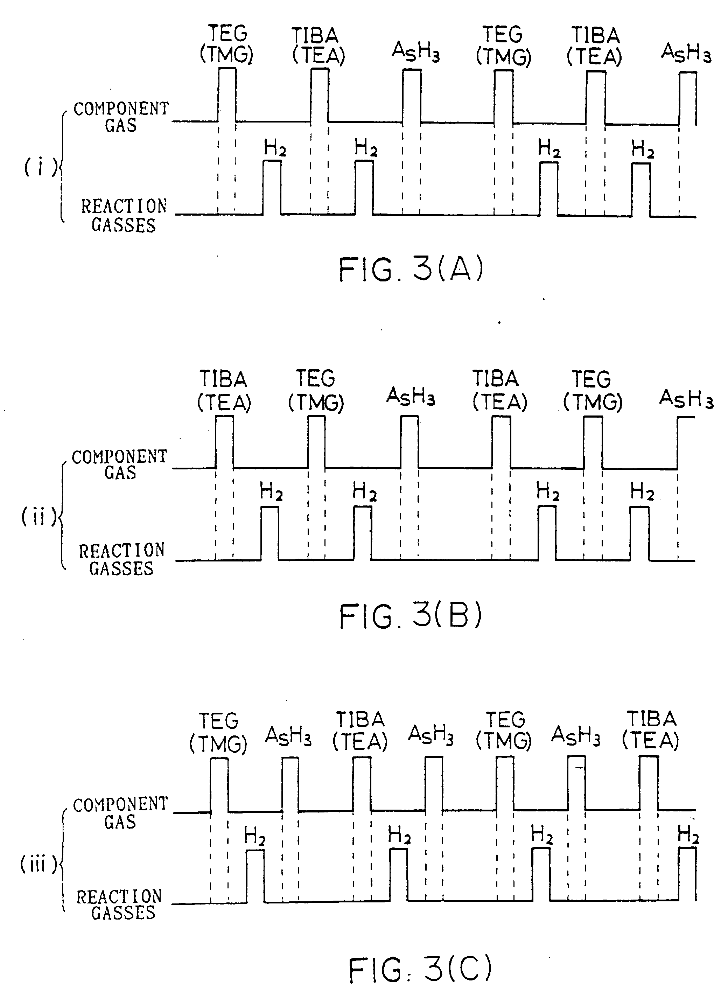

Figs. 3(A) through 3(C) show an embodiment of AlₓGa₁₋ₓAs of non-dope, according to the invention.

The crystal component gasses utilize TEG or TMG as a raw-material gas of Ga, and TIBA or TEA as raw-material gas of Al. Furthermore, the crystal component gasses employ AsH₃ as raw-material gas of As.

(i) through (iii) illustrated in Figs. 3(A) through 3(C) represent gas introduction procedure of AlₓGa₁₋ₓAs growth. Further, the time through which the H₂ is introduced may be simultaneous with the gasses including TEG or TMG and Al, or the former and latter times may partially or completely be overlapped with each other.

In either case, H₂ that is the reaction gas is introduced after or during the organic metal gasses of Ga and As have been or are introduced, whereby it is possible to produce AlₓGa₁₋ₓAs crystal high in purity, by low-temperature growth.

Similarly also to the case where, other than the aforesaid crystal component gasses, DMGaCl, DEGaCl and GaCl₃ are used as the raw-material gasses, and TMA, DMAlH, DEAlH, DMAlCl, DEAlCl and AlCl₃ are employed as the raw-material gas of Al, H₂ that is the reaction gas is introduced after or during the aforementioned gasses have been or are introduced, whereby it is possible to produce AlₓGa₁₋ₓAs crystal high in purity, by low-temperature growth.

Moreover, in the case where the organic metal gas and chloride such as TMAs, TEAs and AsCl₃ are used as the raw-material gas of As, the H₂ that is the reaction gas is introduced after or during the aforesaid gasses have been or are introduced, whereby it is possible to produce the AlₓGa₁₋ₓAs crystal high in purity, by low-temperature growth.

The examples illustrated in Figs. 2 and 3(A) through 3(C) are directed to the crystal growing method of GaAs and AlₓGa₁₋ₓAs. It is to be noted, however, that a similar method can be applied also to molecular-layer epitaxial crystal growth such as GaP, InP, AlAs, InAs, InSb, InₓGaₗ₋ₓAs, AlₓGa₁₋ₓP, InAs_{y}P_{1-y} or the like.

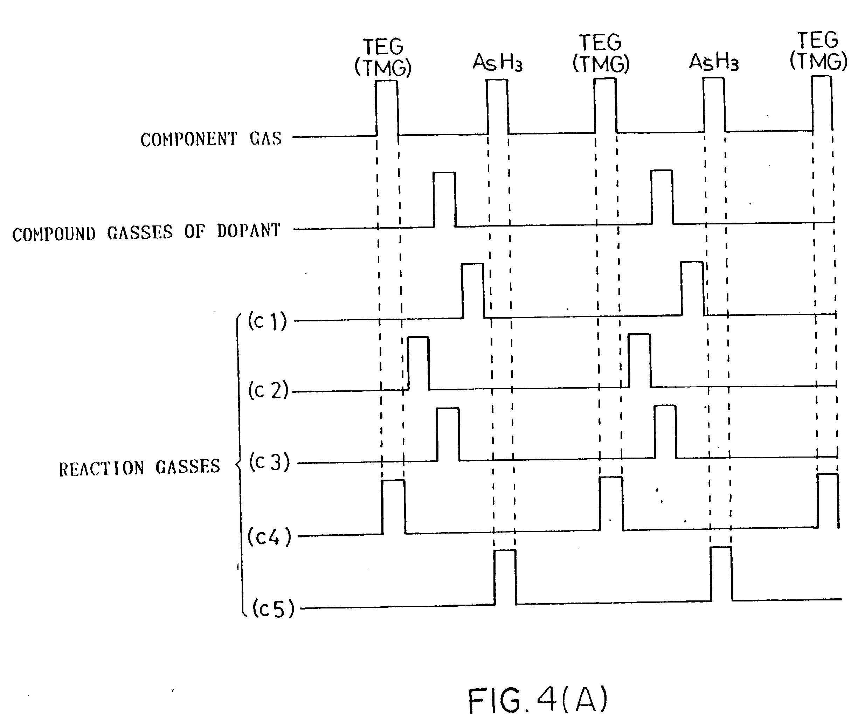

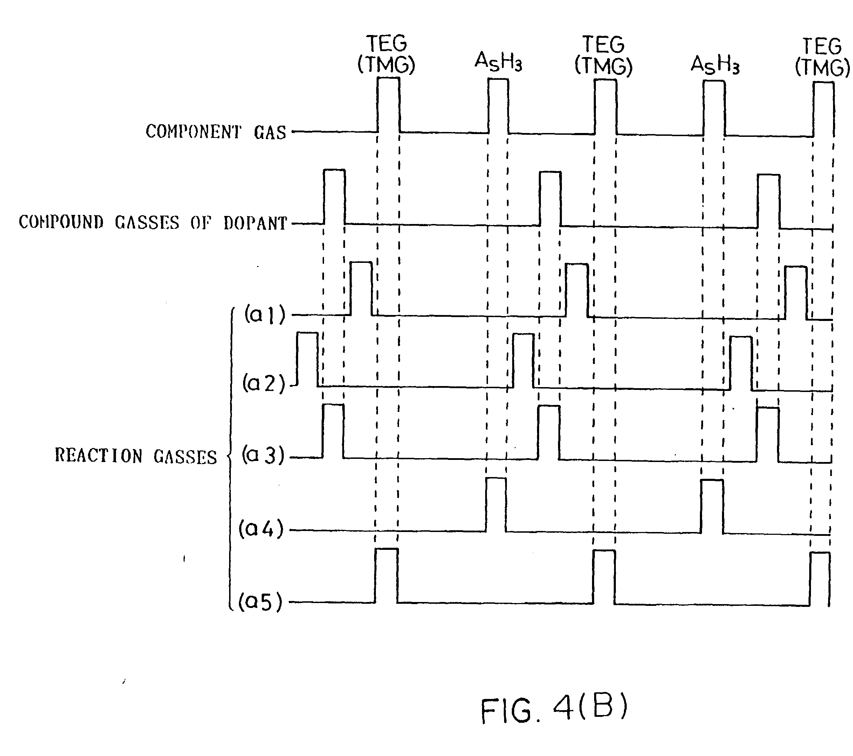

Furthermore, Fig. 4(A) shows an embodiment of a doping method in the molecular-layer epitaxial crystal growth of GaAs, according to the invention.

As illustrated in Fig. 4(A), it will be considered that TEG or TMG of crystal growing gas and ASH₃ are alternately directed onto a substrate crystal heated under vacuum, to perform crystal growth. At this time, in a doping method in which compound gas of the dopant is introduced in synchronism with evacuation and/or introduction of TEG or TMG, the reaction gas is introduced by the following (c1) through (c5) manners (in this connection, the doping method corresponds to the c-mode illustrated in Fig. 5):
(c-1) The reaction gas is introduced after the compound gas of the dopant has been introduced;
(c-2) The reaction gas is introduced just or immediately before the compound gas of the dopant is introduced;
(c-3) The reaction gas is introduced during the period for which compound gas of the dopant is introduced;
(c-4) The reaction gas is introduced at a partial or complete time during introduction of TEG with dopant; and
(c-5) The reaction gas is introduced in overlapped relation to AsH₃.

In the case of the compound gas of the n-type dopant, a VI-group organic metal compound such as DMS, DES, DMSe, DESe, DMTe, DETe or the like, a VI-group hydride such as H₂S, H₃Se or the like, a IV-group hydride such as SiH₄, Si₂H₅, Si₃H₆ or the like, a IV-group organic compound such as Si(CH₃)₄, or the like, is used as the compound gas of dopant.

Further, a II-group organic metal compound such as DMCd, DECd, Bi-CPMg or the like, a IV-group hydride such as GeH₄ or the like, C (carbon) from a methyl group such as TMG or the like is used as the compound of the p-type dopant.

Both the compounds of the n-type and p-type dopant can broadly be divided into an organic metal compound and a hydride.

Furthermore, in place of H₂, the crystal component gasses such as TEG or TMG and AsH₃ may be introduced as the reaction gas. Alternatively, compound gas of dopant may be introduced which is different in kind or type from the compound gas of dopant which is introduced in synchronism with evacuation of the TEG or TMG.

For example, the following items (1) and (2) correspond to (c1) mode shown in Fig. 4(A):
(1) (TEG - Si₂H₆ - TEG - AsH₃), and
(2) (TEG - Si₂H₆ - DESe - AsH₃.
   Si₂H₆ is used as the compound gas of dopant introduced in synchronism with evacuation of the TEG or TMG.

The above-described item (1) illustrates the case where TEG that is one of the crystal component gasses is employed as reaction gas, while the item (2) illustrates the case where DESe that is the compound gas of dopant is used as the reaction gas.

Furthermore, as shown in Fig. 4(B), in the doping method in which the compound gas of dopant is introduced in synchronism with evacuation of AsH₃, the reaction gas is introduced in the following modes (a1) to (a5) (in this connection, the doping method corresponds to the a-mode illustrated in Fig. 5):
(a1) The reaction gas is introduced after introduction of the compound gasses;
(a2) The reaction gas is introduced immediately before introduction of the compound gasses;
(a3) The reaction gas is introduced in synchronism with introduction of the compound gasses during the latter introduction;
(a4) The reaction gas is introduced in staggered relation to introduction of the compound gasses of AsH₃ during the latter introduction; and
(a5) The reaction gas is introduced simultaneously with introduction of TEG.

The VI-group organic metal compound, the VI-group hydride, the IV-group hydride, the IV-group organic metal compound, II-group organic metal compound, TMG and the like are used in the compound gas of dopant.

Moreover, in place of H₂, crystal component gasses such as TEG or TMG, AsH₃ and the like may be introduced as the reaction gas. Alternatively, compound gas of dopant may be introduced which is different in type from the compound gas of dopant introduced in synchronism with and at evacuation of AsH₃.

For example, the following items (3), (4) and (5) correspond to the (a1) mode illustrated in Fig. 4(B):
(3) (TEG - AsH₃ - DESe - AsH₃);
(4) (TEG - AsH₃ - DESe - H₂); and
(5) (TEG - AsH₃ - DESe - H₂Se).

DESe is employed as the compound gas of dopant which is introduced in synchronism with and at evacuation of the AsH₃.

The aforesaid item (3) illustrates the case where AsH₃ of the crystal component gasses is employed as the reaction gas, while the item (4) illustrates the case where H₂ is utilized as the reaction gas. On the other hand, the item (5) illustrates the case where H₂Se of the compound gas of dopant is used as the reaction gas.

In the example of the item (5), since the organic metal compound of Se and the hydride of Se surface-react with each other, it is possible to bring doping density of Se to high density of n ≧ 2 x 10¹⁹ cm⁻³ at the room temperature.

Furthermore, in the aforementioned examples (3) and (4), the ethyl group of the adsorbed DESe or compound of Se reacts with AsH₃ or H₂ of the reaction gas and is desorbed. Thus, it is possible to reduce mixing of C (carbon) into a crystal growing film. Further, since the dopant compound and the hydride of the reaction gas react with each other at low temperature, it is possible to reduce temperature of the crystal growth. Accordingly, since the dopant is not redistributed, it is possible to produce the growing film high in purity.

As described above giving the examples, it is necessary for the reaction gas to select gasses different in type from the gasses directed onto the substrate crystal in precedence.

That is, if the preceding introducing gasses are chloride or an organic metal compound, hydride is introduced as the reaction gas, to hydrogen-reduce Cl, CH₃ or the like within M - Clₙ or M - (CH₃)ₙ (M is a metal element) so that the Cl, CH₃ or the like is removed.

Further, if the preceding introducing gas is hydride, organic metal gas or the like is selected as the reaction gas, making it possible to extremely raise the surface adsorption rate.

Various examples of combination of reaction gas and compound gas of dopant in the doping method in the GaAs molecular-layer epitaxial crystal growth according to the invention are depicted in the below table 1.

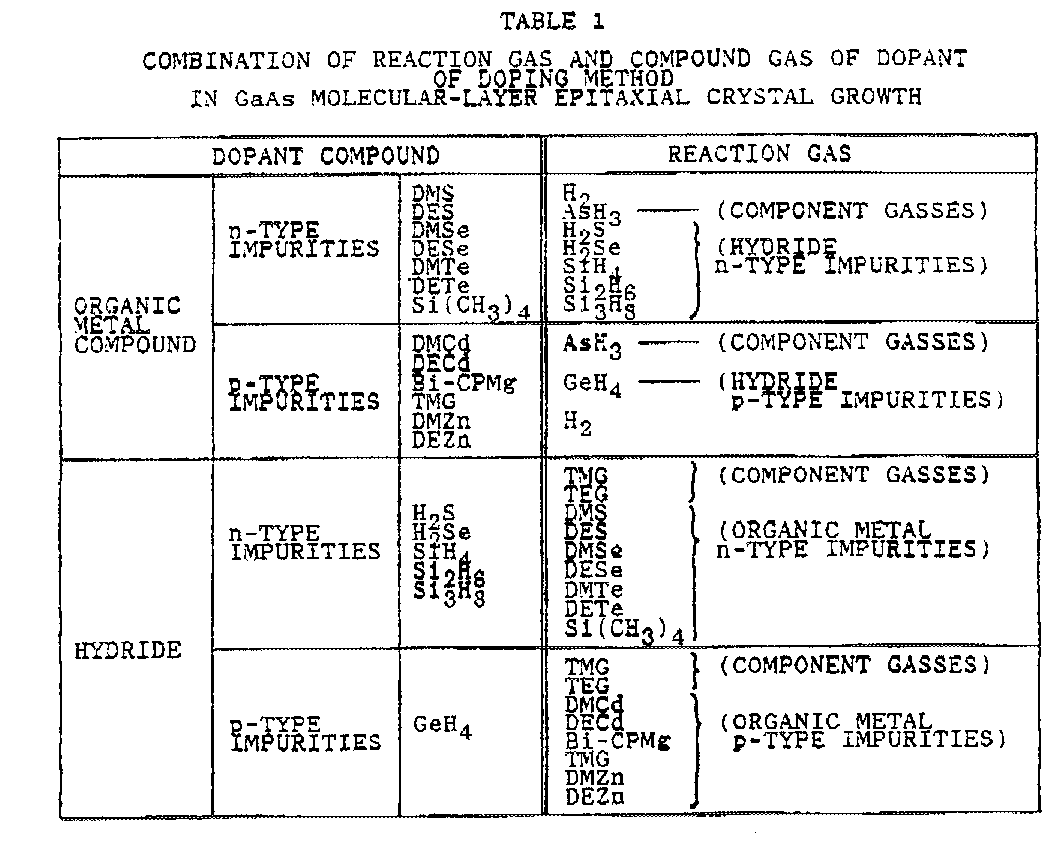

The above-described doping method in the epitaxial crystal growth, according to the invention, can also be applied to molecular-layer epitaxial crystal growth such as AlₓGa₁₋ₓAs, GaP, InP, AlAs, InAs, InSb₂, InₓGa₁₋ₓAs, AlₓGa₁₋ₓP, InAs_{y}P_{1-y} or the like, in addition to GaAs.

Thus, the invention is directed to a technique which is extremely suitable in manufacturing of an active layer required for LSI or super high-speed IC.

## Claims

1. A method of epitaxially growing a compound semiconductor crystal on a substrate crystal (10), wherein a plurality of crystal component gases of a compound semiconductor and reaction gas chemically reacting with the crystal component gases are alternately directed individually onto the substrate crystal (10) heated under vacuum, **characterized** in that as reaction gas one is used which is one of crystal component gases which is different in type from the crystal component gases directed onto the substrate crystal (10) in precedence.

2. A method of doping a compound semiconductor crystal during epitaxially growing said compound semiconductor crystal on a substrate crystal (10), wherein a plurality of crystal component gases of a compound semiconductor and reaction gas chemically reacting with the crystal component gases are alternately directed individually onto the substrate crystal (10) heated under vacuum, and wherein a dopant compound gas is introduced for doping a grown layer, especially according to claim 1, **characterized** in that said dopant compound gas is introduced separately from the crystal component gas followed by the introduction of said reaction gas.

3. The method according to claim 2, characterized in that as reaction gas the crystal component gas which is different in type from the dopant compound gas directed onto the substrate crystal (10) in precedence is used.

4. The method according to claim 2, characterized in that as reaction gas a dopant compound gas which is different in type from the crystal component gases directed onto the substrate crystal (10) in precedence is used.

5. The method according to claim 2, characterized in that as reaction gas a dopant compound gas which is different in type from the dopant compound gas directed onto the substrate crystal (10) in precedence is used.

6. The method according to anyone of the claims 2 to 5, characterized in that a dopant compound gas containing Si, Ge, S, Se, Te, Zn, Cd or Mg is used.

7. The method according to anyone of the claims 2 to 6, characterized in that the reaction gas chemically reacting with the crystal component gases and the dopant compound gas is directed onto the substrate crystal (10) in overlapping relationship to the dopant compound gas.

8. The method according to claim 7, characterized in that the reaction gas is only partially overlapped with the dopant compound gas.

9. The method according to anyone of the claims 1 to 8, characterized in that the crystal component gases containing group III and group V elements are used.

## Patentansprüche

1. Verfahren zum epitaktischen Wachstum eines Verbindungshalbleiterkristalls auf einem Substratkristall (10), wobei eine Vielzahl von Kristallkomponentengasen eines Verbindungshalbleiters und Reaktionsgas, das chemisch mit den Kristallkomponentengasen reagiert, abwechselnd individuell auf das unter Vakuum erhitzte Substratkristall (10) geleitet werden, dadurch **gekennzeichnet**, daß als Reaktionsgas eines verwendet wird, das eines der Kristallkomponentengase ist, das von anderem Typ als die Kristallkomponentengase ist, die auf das Substratkristall (10) vorher geleitet wurden.

2. Verfahren zum Dotieren eines Verbindungshalbleiterkristalls während des epitaktischen Wachstums besagten Verbindungshalbleiterkristalls auf einem Substratkristall (10), wobei eine Vielzahl von Kristallkomponentengasen eines Verbindungshalbleiters und Reaktionsgas, das chemisch mit den Kristallkomponentengasen reagiert, abwechselnd individuell auf das unter Vakuum erhitzte Substratkristall (10) geleitet werden, und wobei ein Dotierungsmittelverbindungsgas zum Dotieren einer gewachsenen Schicht eingeleitet wird, insbesondere nach Anspruch 1, dadurch **gekennzeichnet**, daß besagtes Dotierungsmittelverbindungsgas separat vom Kristallkomponentengas, gefolgt von der Einleitung besagten Reaktionsgases, eingeleitet wird.

3. Verfahren nach Anspruch 2, dadurch gekennzeichnet, daß als Reaktionsgas das Kristallkomponentengas, das im Typ verschieden von dem Dotierungsmittelverbindungsgas ist, das auf den Substratkristall (10) vorher gerichtet wurde, verwendet wird.

4. Verfahren nach Anspruch 2, dadurch gekennzeichnet, daß als Reaktionsgas ein Dotierungsmittelverbindungsgas, das im Typ verschieden von dem Kristallkomponentengas, das auf den Substratkristall (10) vorher gerichtet wurde, verwendet wird.

5. Verfahren nach Anspruch 2, dadurch gekennzeichnet, daß als Reaktionsgas ein Dotierungsmittelverbindungsgas, das im Typ verschieden von dem Dotierungsmittelverbindungsgas, das auf den Substratkristall (10) vorher gerichtet wurde, verwendet wird.

6. Verfahren nach einem der Ansprüche 2 bis 5, dadurch gekennzeichnet, daß ein Dotierungsmittelverbindungsgas enthaltend Si, Ge, S, Se, Te, Zn, Cd oder Mg verwendet wird.

7. Verfahren nach einem der Ansprüche 2 bis 6, dadurch gekennzeichnet, daß das Reaktionsgas, das chemisch mit dem Kristallkomponentengas und dem Dotierungsmittelverbindungsgas reagiert, auf den Substratkristall (10) überlappend mit dem Dotierungsmittelverbindungsgas gerichtet wird.

8. Verfahren nach Anspruch 7, dadurch gekennzeichnet, daß das Reaktionsgas nur teilweise überlappend mit dem Dotierungsmittelverbindungsgas ist.

9. Verfahren nach einem der Ansprüche 1 bis 8, dadurch gekennzeichnet, daß die Kristallkomponentengase, enthaltend Elemente der Gruppe III und V, verwendet werden.

## Revendications

1. Procédé de croissance épitaxiale d'un cristal semi-conducteur composite sur un cristal de substrat (10), dans lequel une pluralité de gaz entrant dans la composition du cristal d'un semi-conducteur composite et un gaz réactif réagissant chimiquement avec les gaz entrant dans la composition du cristal sont alternativement dirigés individuellement sur le cristal de substrat (10) chauffé sous vide, caractérisé en ce qu'on utilise pour le gaz réactif, un gaz qui est l'un des gaz composant le cristal, de type différent des gaz entrant dans la composition du cristal et envoyés préalablement sur le cristal de substrat (10).

2. Procédé de dopage d'un cristal semi-conducteur composite pendant la croissance épitaxiale dudit cristal semi-conducteur composite sur un cristal de substrat (10), dans lequel une pluralité de gaz entrant dans la composition du cristal d'un semi-conducteur composite et un gaz réactif réagissant chimiquement avec les gaz entrant dans la composition du cristal sont alternativement dirigés individuellement sur le cristal de substrat (10) chauffé sous vide, et dans lequel un gaz composite dopant est introduit pour doper une couche après sa croissance, en particulier selon la revendication 1, caractérisé en ce que ledit gaz composite dopant est introduit séparément du gaz entrant dans la composition du cristal suivi par l'introduction dudit gaz réactif.

3. Procédé selon la revendication 2, caractérisé en ce qu'on utilise d'abord comme gaz réactif le gaz entrant dans la composition du cristal qui est de type différent du gaz composite dopant dirigé sur le cristal de substrat (10) précédement.

4. Procédé selon la revendication 2, caractérisé en ce que l'on utilise d'abord comme gaz réactif un gaz composite dopant qui est de type différent des gaz entrant dans la composition du cristal dirigés sur le cristal de substrat (10) précédemment.

5. Procédé selon la revendication 2, caractérisé en ce que l'on utilise d'abord comme gaz réactif un gaz composite dopant qui est de type différent du gaz composite dopant dirigé sur le cristal de substrat (10) précédemment.

6. Procédé selon l'une quelconque des revendications 2 à 5, caractérisé en ce qu'on utilise un gaz composite dopant contenant du Si, Ge, S, Se, Te, Zn, Cd ou Mg.

7. Procédé selon l'une quelconque des revendications 2 à 5, caractérisé en ce que le gaz réactif réagissant chimiquement avec les gaz entrant dans la composition du cristal et le gaz composite dopant sont dirigés sur le cristal de substrat (10) en recouvrement par rapport au gaz composite dopant.

8. Procédé selon la revendication 7, caractérisé en ce que le gaz réactif est seulement partiellement recouvert par le gaz composite dopant.

9. Procédé selon l'une quelconque des revendications 1 à 8, caractérisé en ce qu'on utilise les gaz de composition du cristal contenant des éléments du groupe III et du groupe V.
